(19) Europäisches Patentamt
European Patent Office
Office européen des brevets

(11) Numéro de publication: **0 010 070**
**B1**

# (12) FASCICULE DE BREVET EUROPEEN

(45) Date de publication du fascicule du brevet: **09.02.83**

(51) Int. Cl.³: **C 23 C 15/00**, G 04 B 31/08

(21) Numéro de dépôt: **79810117.6**

(22) Date de dépôt: **08.10.79**

## (54) Procédé pour déposer sur des substrats par pulvérisation cathodique un revêtement autolubrifiant de chalcogénures métalliques.

(30) Priorité: **09.10.78 CH 10455/78**

(43) Date de publication de la demande:
**16.04.80 Bulletin 80/8**

(45) Mention de la délivrance du brevet:
**09.02.83 Bulletin 83/6**

(84) Etats contractants désignés:
**AT CH DE FR GB IT NL SE**

(56) Documents cités:
**CH - A - 431 395**
**US - A - 4 025 410**

**THIN SOLID FILMS vol. 11, 1972, Elsevier Sequoia S.A. Lausanne, CH, N.W. PRICE et al.: "Sputtered molybdenum disulphide as a lubricant for instrument slip rings", pages 191—194**
**ASLE TRANSACTIONS, vol. 14, no. 4, 1971, TALIVALDIS SPALVINS: "Lubrication with sputtered MoS2 films", pages 267—274**

(73) Titulaire: **ASU Composants S.A.**
**CH-2316 Les Ponts-de-Martel (CH)**

(72) Inventeur: **Bergmann, Erich**
**Rue des Bains 26**
**CH-2503 Bienne (CH)**
Inventeur: **Melet, Georges**
**Rue des Boudines 15**
**CH-1217 Meyrin (CH)**

(74) Mandataire: **Klein, André Gilbert et al,**
**Société Générale de l'Horlogerie Suisse S.A.**
**ASUAG 6, Faubourg du Lac**
**CH-2501 Biel/Bienne (CH)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

EP 0 010 070 B1

# Procede pour deposer sur des substrats, par pulverisation cathodique, un revetement auto-lubrifiant de chalcogenures metalliques

Domaine technique

La présente invention a pour objets un procédé utilisable pour revêtir des substrats, par pulvérisation cathodique, d'une couche auto-lubrifainte de chalcogénures métalliques.

Par chalcogénures métalliques, on entend ici des sulfures, séléniures et tellurures métalliques, choisis parmi le bisé léniure de niobium, le disulfure de molybdéne et le disulfure de tungsténe que permmettent la constitution de couches à faible coefficient de friction utilisable pour revêtir des pièces métalliques en frottement à sec, en faciliter le glissement et en dimunuer l'usure.

Technique antérieure

Le dépôt, par pulvérisation cathodique, de couches anti-friction de sulfure de molybdène est déjà connu. Ainsi Spalvins (ASLE Transactions *14* [4], 267—274 (1971); NASA TM X-71742 (1975) décrit le dépôt de telles couches sur des surfaces métalliques à haut degré de polissage ($5 \times 10^{-2}$ $\mu$m) en utilisant la technique connue sous le nom de pulvérisation à radio-fréquence et polarisation DC. Spalvins a utilisé une cible de $MoS_2$ pur et travaillé dans des conditions permettant d'obtenir sur différents substrats (Ni, Au, Ag, Co, Mo, W, Ti, Al, des aciers, le verre et certaines résines synthétiques) des dépôts adhérents amorphes ou microcristallins auto-lubrifiants, à la vitesse d'environ 0,015 $\mu$m à la minute. De tels films présentaient des coefficients de friction (mesurés dans le vide poussé grâce au dispositif "disque et bille" décrit plus loin) de l'ordre de 0,03 à 0,04 pour des épaisseurs de 0,2 à 0,65 $\mu$m. Cependant, ce procédé présente certains inconvénients. Ainsi, à cause de sa faible efficacité, il ne permet guère d'obtenir des dépôts dont l'épaisseur dépasse sensiblement 0,5 à 1 $\mu$m et il a tendance à former des excroissances de $MoS_2$ sur les inégalités des substrats, ce qui nécessite, pour l'obtention de revêtements antifriction utilisables industriellement, que les substrats à plaquer soient très hautement polis. De plus, la structure des dépôts ne présente pas des qualités très favorables de résistance à l'usure surtout lorsqu'il fait humide. Finalement, et ceci pour une raison inconnue, les dépôts obtenus par la méthode Spalvins n'adhérent pas au cuivre et au bronze, ce qui est un inconvénient grave dans le cas de revêtements anti-friction destinés à des paliers ou des pièces de micro-mécanique souvent fabriquées en laition ou en bronze. On peut encore citer comme faisant partie de l'état de la technique les documents suivants: THIN SOLIDS FILMS, Vol 11, 1972, Elsevier Sequoia, Lausanne, CH. N. W. PRICE et al: "Sputtered Molybdenum disulphide as lubricant for instrument slip-rings", pages 191—194; Brevet CH—A—431.395 (EBAUCHES SA) et brevet USA—4,025,410 (W. W. STEWART) lequel décrit un dispositif de pulvérisation sous champ magnétique dont les lignes de forces sont dirigées radialement par rapport à la cible. Cependant les distances substrate cible, aux pressions, employeés, ne correspondent pas au libre parcours moyen des molécules arracheés à la cible et ne permettent pas d'obtenir des revêtements de structure turbostratique.

Exposé de l'invention

Le procédé l'invention remédie à ces inconvénents; il est caractérisé par le fait que l'espace cathodique de la cible (c'est-à-dire la région où se produisent les phénomènes engendrant la formation des ions responsables de la pulvérisation) est soumis à un champ magnétique, que la distance entre cette cibre et le substrat à revêtir correspond au libre parcours moyen des fragments pulvérisés de la cible (en général, de 1,5 à 7 cm suivant les pressions de pulvérisation qui peuvent varier, le plus souvent, entre $2 \cdot 10^{-3}$ et $8 \cdot 10^{-4}$ Torr $266 \times 10^{-3}$ et $1050 \times 10^{-4}$ Pascal, soit) et que la densité du courant de pulvérisation est telle que la vitesse de dépôt, sur la surface de substrat faisant face à la cible, soit d'au moins 0,1 $\mu$m par minutes. Dans ces conditions, le dépôt est régulier et il n'est plus besoin de se préoccuper particulièrement de l'état de surface du substrat avant revêtement. Bien au contraire, on a constaté qu'une certaine rugosité du substrat favorise l'adhérence des présents dépôts auto-lubrifiants.

Par ailleurs, la composition des revêtements obtenus par pulvérisation cathodique ne reproduit pas fidèlement, en général, celle du matériau de la cible et, le plus souvent, les dépôts de $MoS_2$ obtenus à partir de $MoS_2$ pulvérisé sont souvent déficients en soufre et riches en molybdène ou vice versa et leurs propriétés physiques peuvent en être affectées.

La composition de pulverisation utiliseé pour la mise en oeuvre du procédés de l'invention est choisie de maniere à remédier à ces inconvénients.

Cette composition est caractérisée par le fait qu'elle comprend, en mélange avec le ou des chalcogénures métalliques à déposer, un excès de l'un ou de l'autre des composants métalliques ou métalloïdiques de celui-ci ou de ceux-ci à l'état élémentaire, le tout sous forme d'une poudre à l'état compacté logée dans le réceptacle cathodique du dispositif de pulvérisation en constituant la cible de celui-ci.

Meilleures manières de réaliser l'invention

Le contenu en chalcogène ou en métal libre de la présente composition à pulvériser cathodiquement peut être très variable suivant les besoins, ceux-ci étant, bien entendu, fonction des conditions de fonctionnement de la pièce traitée. Par exemple, dans le cas de sulfure de molybdène, la composition peut contenir, sous forme de mélange de poudres, du $MoS_2$ pur avec de 0,001% à quelques pourcents de soufre ou de molybdène élémentaires, la quantité exacte de ces éléments dépendant des conditions opératoires de la pulvérisation et de la composition déterminés de dépôt qu'on désire obtenir (dépôt) pauvre en soufre, ou correspondant stoechiométriquement à la formule $MoS_2$, ou riche en soufre). On verra plus loin, dans la partie spéciale de la présente description, qu'on a pu établir une relation précise entre la composition de la cible et celle du dépôt des autres chalcogénures et de leurs mélanges avec un ou plusieurs chalcogènes libres. Ainsi, par exemple, le procédé convient pour déposer des couches mixtes de sulfure et séléniure de molybdène pouvant contenir un excès de soufre, de sélénium ou de ces deux métalloïdes.

Dans le procédé de l'invention, le champ magnétique auquel est soumis l'espace cathodique peut être fourni par un aimant permanent faisant partie du support cathodique (dispositif "cathode magnétron" décrit, par exemple, dans la publication suivante: Catalogue VIDE 1976, la Physique Appliquée Industrie, 16 rue André-Ampère, 700—95004 Cergy, France). Par ailleurs, le dispositif de pulvérisation cathodique permettant de metre en oeuvre le présent procédé peut être un appareil commercial quelconque possédant les caractéristiques adéquates. A ce titre, on peut citer l'appareil "S-GUN thin film source" de la Société VARIAN, Palo-Alto, Californie.

On ne connait pas exactement les raisons pour lesquelles le présent procédé ne donne pas lieu à la formation d'excroissances comme dans le cas des procédés antérieurs. On pense cependant que cet effet est en rapport avec la vitesse de dépôt qui est très supérieure à celle des ancients procédés.

Pour réaliser de telles vitesses de dépôts, on opère avantageusement sous une tension cathodique de 400 à 800 volt et sous une densité de courant cathodique de 5 à 20 $mA/cm^2$, le champ magnétique étant de l'ordre de 45 à $100 \cdot 10^3$ A/m.

Pour préparer la composition de l'invention sous sa forme de cible pour pulvérisation cathodique on mélange, par exemple dans le cas d'un produit riche en chalcogène, le chalcogénure en poudre avec le cahlcogène également en poudre avec le chalcogène également en la cathode de ce mélange et on soumet le tout à une forte pression, par exemple de l'ordre de 0,5 à $1 \times 10^8$ Pascal de manière que la poudre se prenne en bloc.

Pour la mise en oeuvre pratique de présent procédé on procède avantageusement comme suit: On sélectionne les pièces à plaquer (celles-ci peuvent être des plaquettes échantillon ou des pièces de mécanique), on les décape mécaniquement et on les nettoie par un procédé habituel et on les dispose sur le porte-substrat d'un appareil de pulvérisation cathodique. Eventuellement, on masque les zones des pièces ne devant pas être plaquées (par un écran, une épargne ou par l'emploi d'un porte-objet ajouré). On fixe le porte-cible contenant la présente composition pressée sur le support de cathode, on ferme l'appareil et on y fait le vide. Puis on introduit un gaz rare (Ar, Kr, Xe) sous une pression de l'ordre de $10^{-2}$ Torr ($133 \times 10^{-2}$ Pascal), on met l'appareil sous tension et on procède à un décapage ionique préliminaire des substrats en polarisant ceux-ci de manière appropriée. Puis on abaisse la pression entre environ $2 \cdot 10^{-3}$ et $8 \cdot 10^{-4}$ Torr ($266 \times 10^{-3}$ et $1050 \times 10^{-4}$ Pascal) on polarise la cathode sous une tension comprise entre les valeurs de tensions ci-dessus et on commence la pulvérisation proprement dite, l'opération de décapage n'étant arrêtée qu'après coup pour éviter que les impuretés arrachées lors du décapage ne se redéposent sur les pièces au début de l'opération de pulvérisation. On continue le dépôt jusqu'à obtention d'un film d'une épaisseur d'environ 0,2 à 3 $\mu$m, des épaisseurs de l'ordre de 1,5 $\mu$m étant les plus favorables au point de vue lubrification. On peut effectuer cet dépôts à diverses températures en chauffant les substrats au moyen d'une résistance incorporée au porte-objet. On préfère cependant travailler à température ordinaire, les dépôts obtenus dans ces conditions ayant une structure cristalline satisfaisante pour l'usage prévu.

La nature de la matière des substrats peut être quelconque. Dans la pratique, on a revêtu, par le présent procédé, des pièces de laiton, cuivre, différents aciers, or, nickel, manifor (un alliage Mn-Ni-Cu), etc., sans canstater de différences notables dans les propriétes des dépôts en fonction du substrat.

Les revêtements autolubrifiants qu'on obtient suivant le procédé de l'invention sont "turbostratique" pour $NbSe_2$, $MoS_2$ et $WS_2$. La forme turbostratique, définie plus loin, constitue une forme de dépôt auto-lubrifiant particulièrement intéressante à cause de sa remarquable résistance à l'abrasion, la longue durée de vie des pièces en frottement qui en sont munies, et à son indifférence aux conditions climatiques extérieures, notamment à l'humidité ambiante.

La morphologie "turbostratique", qui peut être décelée par les spectres de diffraction aux rayons X (présence d'un pic unique d'indice 002, alors que l'état lamellaire cristallin se distingue par la présence de plusieurs pics, par exemple, 110, 105, 103, 100, 002 et l'état amorphe par une absence de pics), est définie par les inventeurs de la manière suivante:

Etats de cristallisation:

Dans les substances courantes comme les métaux ou les céramiques, la cristallinité peut varier du monocristal, passant par les états polycristallins de plus en plus fins, jusqu'à l'état dit "amorphe". Ces états sont plus ou moins isotropiques, c'est-à-dire avec des propriétés à peu près uniformes dans toutes les directions.

Dans une structure lamellaire en couches (structure feuilletée), comme le $MoS_2$, le graphite, le mica, etc., les propriétés sont très anisotropiques dés le début. A l'intérieur des "feuilles" (nous appelons ici "feuille" une couche cristalline d'une épaisseur monomoléculaire) le type des liaisons est covalent en entre les feuilles du type Van der Waals, ce qui rend ces substances facilement clivables. Ainsi, les états de cristallisation sont différents de ceux mentionnés ci-dessus. Ici, un monocristal est effectivement une pile de monocristaux de deux dimensions. Dans une série avec une décroissance du degré de cristallisation, c'est d'une part la dimension latérale des feuilles et d'autre part la coordination relative de l'orientation des différentes feuilles (ou petits paquets de feuilles) qui diminuent. Ce stade est appelé un état "turbostratique". Les normales de toutes les feuilles sont pratiquement parallèles, mais la rotation autour de cette normale est arbitraire. Alors, même dans un état de faible cristallisation la couche du dépôt entier est fortement anisotropique. La cristallisation peut se dégrader jusqu'à un état "amorphe" pratiquement isotropique où tout ce qui reste de feuilles a la dimension d'un petit amas d'atomes". L'état "turbostratique" est également défini par W. BOLLMANN dans Electron Microscope Study of Radiation Damages in Graphite, J. Appl. Physics *32*, 869—876 (1961).

Les exemples qui suivant illustrent l'invention en détail. Pour une meilleure compréhension des exemples on se référa au dessin en annexe.

Applications industrielles

La figure 1 est un schéma d'une installation de pulvérisation cathodique.

La figure 2 est un graphique montrant la relation entre le pourcentage de soufre des compositions, suivant l'invention, pour le dépôt du $MoS_2$ et celui desdits dépôts obtenus par pulvérisation cathodique.

La figure 3 est un graphique montrant la variation du coefficient de friction $\eta$ de deux dépôts de $MoS_2$ en fonction du temps de frottement.

La figure 4 est un graphique du même type que celui de la figure 3.

La figure 5 est un graphique montrant la variaton du coefficient de friction en fonction de l'épaisseur du dépôt et suivant l'état de préparation de surface du substrat avant revêtement.

Exemple 1

On prépare 3 poudres A, B et C destinées à constituer les cibles d'un appareil de pulvérisation cathodique de la manière suivante:

A: On utilise 20 g de sulfure de molybdène (MERCK, qualité puriss.) dont l'analyse indique qu'elle contient 61,96% de Mo et 38,03% de S, d'autres éléments n'étant pas décelables par les moyens d'analyse utilisés (gravimétrie). En fait, cette composition ne correspond pas exactement à du $MoS_2$ pour (lequel devrait contenir 59,94% de Mo et 40,06% de S), mais plutôt à une sulfure de molybdène contenant un léger excès de métal libre (formule calculée $Mo_{1,089}S_2$).

B: A un autre lot de 20 g du sulfure de molybdène constituant la composition A ci-dessus, on ajoute 1,74 g de soufre pour (FLUKA) de manière à porter la concentration en soufre du tout à 43%.

C: On procéde de même avec un troisième lot et on ajoute 4,08 g de S à 20 g du sulfure de molybdène (MERCK) de manière à porter la concentration en soufre à 48,5%.

On passe les trois compositions dans un broyeur-mélangeur de façon à réaliser des poudres fines intimement mélangées.

Puis on introduit la poudre A dans la cavité d'un disque portecible d'un appareil de pulvérisation cathodique (plaque en Al ou en anti-corrodal de 5 mm d'épaisseur munie d'une creusure circulaire de 60 mm de diamètre et de 2 mm de profondeur). On tasse bien la poudre en la régularisant et, après avoir intercalé une rondelle de papier anti-adhérant, on la soumet à une pression de $0,6 \times 10^8$ Pascal produite par le piston d'une presse hydraulique. Après quelques secondes on obtient ainsi un gâteau homogène et solide de poudre compactée.

Par ailleurs, on sélectionne un certain nombre de plaquettes échantillon s'adaptant au porte-substrat de l'appareil de pulvérisation cathodique. Ces plaquettes, rectangles de $40 \times 20 \times 1$ mm ou disques $\phi$ 17 mm, épaisseur 1,4 mm, sont choisies en cuivre, laiton, bronze, fer, nickel, manifor et sont placées dans ledit portesubstrat de manière à recevoir un dépôt par pulvérisation. Pour la préparation de surface de ces plaquettes, on a utilisé les méthodes suivantes:

Polissage 1 (P-1): Polissage grossier avec une bande abrasive de 125 $\mu$m

Polissage 2 (P-2): Polissage plus fin avec une pâte de 15 $\mu$m

Polissage 3 (P-3): Polissage fin avec une pâte finale de 0,25 $\mu$m.

Après le polissage les plaquettes ont été décapées mécaniquement, puis dégraissées dans le trichloréthylène chaud (5 min.) puis rincées à l'alcool et séchées.

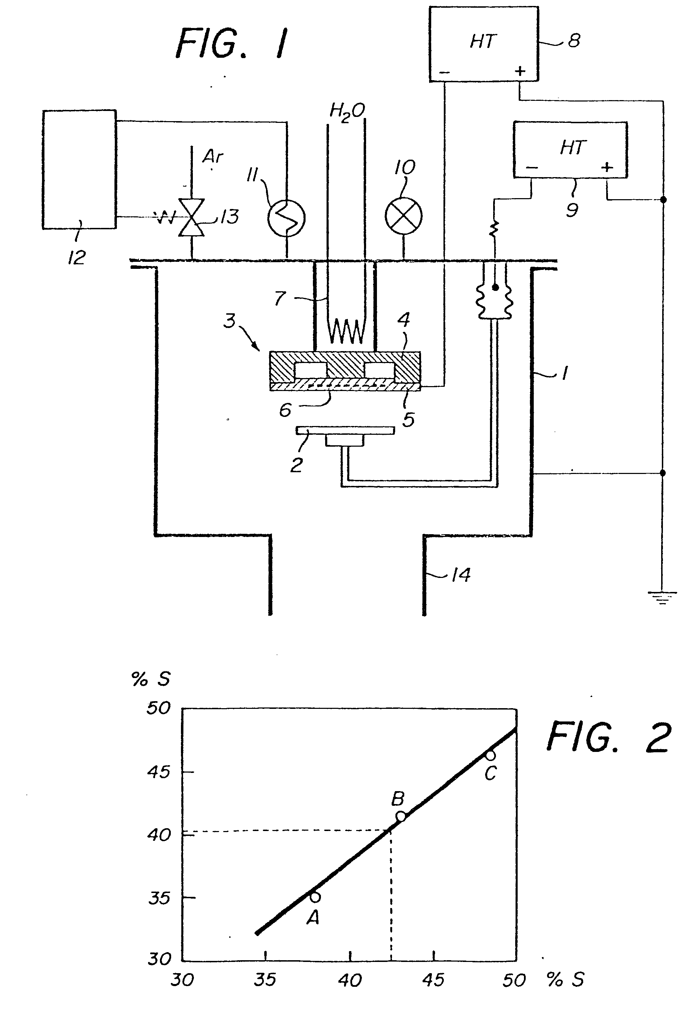

L'appareil de pulvérisation cathodique utilisé est représenté schématiquement à la figure 1. Cet appareil comprend une enceinte 1 étanche contenant d'une part un porte-substrat 2 et une cathode 3. Cette cathode comprend, en tant qu'organes essentiels (les seuls représentés ici) un aimant 4, un eplaque porte-cible 5 dans laquelle est ménagée une creusure 6 remplie de la poudre compactée à pulvériser comme on l'a vu plus haut et, pour refroidir le tout, une circulation 7 de liquide réfrigérant, par exemple $H_2O$. Le présent appareil est alimenté par deux sources de haute tension, l'une 8 pour la polarisation de la cathode et l'autre 9, pour polariser les substrats pendant le décapage ionique préliminaire.

Finalement, en ce qui concerne l'alimentation en gaz rare d'ionisation, le présent appareil comprend encore une jauge de lecture des pressions 10 et un dispositif auto-régulateur de ladite pression composé d'une jauge de commande 11, pilotant un régulateur électronique 12, celui-ci agissant sur une vanne 13 d'entrée du gaz (par exemple Ar) de manière à maintenir à une valeur constante et prédéterminée la pression de ce gaz pendant la pulvérisation. Par ailleurs, l'appareil comprend encore un conduit d'évacuation 14 relié à la pompe à vide non représentée.

A titre indicatif, les organes fonctionnels du présent appareil ont été choisis parmi les produits commerciaux suivants:

Alimentation HT (8): 0 à 2,4 KV, courant jusqu'a 400 mA.

Alimentation HT (9): Générateur WITTMER 0—2000 V, courant jusqu'à 30 mA, séparée du porte-substrat par 100 kΩ.

Jauge (10): Jauge thermocouples HASTINGS DV6-M

Jauge (11): PIRANI BALZERS NV4 Régulateur (12): Coffret de contrôle BALZERS RVG2

Vanne (13): BALZERS RV27E

Après avoir disposé les plaquettes sur le porte-substrat 2, on fixe le porte-cible contenant la poudre A pressée sur la cathode 3 et on règle la distance entre celle-ci et le substrat de manière qu'elle corresponde au libre parcours moyen de particules de matériau pulvérisé, c'est-à-dire environ 3 à 6 mm dans les conditions opératoires du présent Exemple. On ferme l'appareil et on y fait le vide ($133 \times 10^{-5}$—$133 \times 10^{-6}$ Pascal) avec une pompe à diffusion de type BALZERS PST 900A.

Puis, par l'entremise de la vanne 13 on introduit de l'argon à 99,9% provenant d'un cylindre et on règle la pression à $5 \cdot 10^{-2}$ Torr. On polarise le porte-objet et on procède pendant 6 min au décapage ionique des plaquettes de substrat sous un courant de 2mA. Puis, sans arrêter le courant de décapage, on règle la pression d'argon à $266 \times 10^{-3}$ Pascal, on enclenche le courant de pulvérisation de manière que les deux effets se superposent, ceci pour éviter une retombée des produits de décapage sur le substrat. Après quelques secondes on coupe le circuit de décapage et on laisse le dépôt se poursuivre sous 7 mA/cm$^2$ de cible, ce qui donne une vitesse de dépôt de 0,1 $\mu$m/min.

Lorsqu'on estime qu'il s'est déposé environ 1,5 à 1,8 $\mu$m de produit auto-lubrifiant, on arrête l'opération et on retire les plaquettes de l'appareil afin de les soumettre aux analyses et aux tests de friction et on répète la même opération sur d'autres substrats en utilisant successivement comme cibles les compositions B et C.

Puis on recommence le tout avec d'autres plaquettes en laisant la pulvérisation s'effectuer pendant des périodes différentes, de manière à obtenir toute une gamme d'échantillons de matières diverses, recouverts de films de compositions et d'épaisseurs différentes et déposés sur des surfaces de finitions différentes.

Les compositions chimiques des dépôts ont été analysées et portées sur un graphique en fonction de celles des poudres correspondantes ayant servi de cible (voir fig. 2). On constate, d'après ce graphique, qu'il existe, dans les conditions opératoires précitées, une relation pratiquement linéaire entre la composition des mélanges de départ et celle des revêtements. On voit aussi qu'a une composition pulvérisable contentant 42,8% de S correspond un dépôt contenant 40,06% de soufre (quantité stoechiométrique correspondant à la formule $MoS_2$).

Les tests de friction auxquels ont été ensuite soumis ces échantillons sont les suivants:

I. Test de "disque et bille": L'appareil utilisé pour cet essai, dont une forme est décrite dans ASLE transactions *14*, [4], 267—274, comprend un disque support sur lequel on monte l'ćhantillon à tester sour forme d'une plaquette de forme circulaire contre laquelle applique une butée à bille dont la pression contre l'échantillon est réglable et qui comporte un jeu de jauges de contrainte permettant de mesurer la force de frottement entre la bille et l'échantillon. Le disque étant mis en rotation à une vitesse déterminée, on note le nombre de tours ou le temps nécessaire pour éroder le dépôt (c'est-à-dire provoquer une augmentation notable de la friction) sous une pression déterminée de la bille. Pour les présents tests "disque et bille" on a utilisé les paramètres suivants:

Bille $\phi$ 0,7 mm, acier ou rubis synthétique; vitesse de déplacement 1 cm/sec; charge 56 kg/mm$^2$; pression et température ambiante.

II. Pendule de Barker: Ce pendule est constitué d'un balancier métallique rigide muni d'un poids réglable et dont l'organe de pivotement (une rotule sphérique) respose entre deux surfaces planes disposées en V, l'angle de celui-ci étant de 90°. Pour la mesure, on place les revêtements à tester sur les surfaces du V en contact avec la rotule, on déplace le bras du pendule de sa position d'équilibre d'un angle déterminé par une échelle graduée, on le libère afin qu'il entre en balancement et, après un nombre déterminé de périodes, on lit la valeur de l'amplitude du dernier balancement. Le coefficient de friction $\eta$ est lié aux paramètres ci-dessus par la relation suivante:

$$\eta = K \cdot \frac{Ao - Af}{N} \quad \text{où}$$

Ao=amplitude initiale; Af=amplitude finale; N=nombre de battements; k=coefficient dépendent du poids du pendule. Dans le cas d'espèce k=0,0735 (poids de 1 kg).

L'épaisseur des dépôts a été mesurée par interférométrie suivant les moyens habituels et, plus spécialement, par la méthode "TALYSURF". Pour l'application de cette méthode, on utilise un comparateur enregistreur dont le curseur se déplace linéairement sur la surface à étrudier et qui enregistre (en les amplifant foretment) les différences de niveaux rencontrés par ce curseur. Pour pouvoir mesurer l'épaisseur d'un dépôt, on applique préalablement sur le substrat, avant revêtement, un fil métallique qui, une fois le film déposé, laisse après arrachage une trace dont la profondeur correspond à l'épaisseur à mesurer.

Les résultats des tests ci-dessus sur les différents échantillons de placage préparés suivant le présent exemple ont permis de mettre en relation les qualités auto-lubrifiantes des dépôts de sulfure de molybdène "turbostratiques" avec les variables suivantes: l'état de surface du substrat, l'épaisseur du dépôt et la composition de celui-ci.

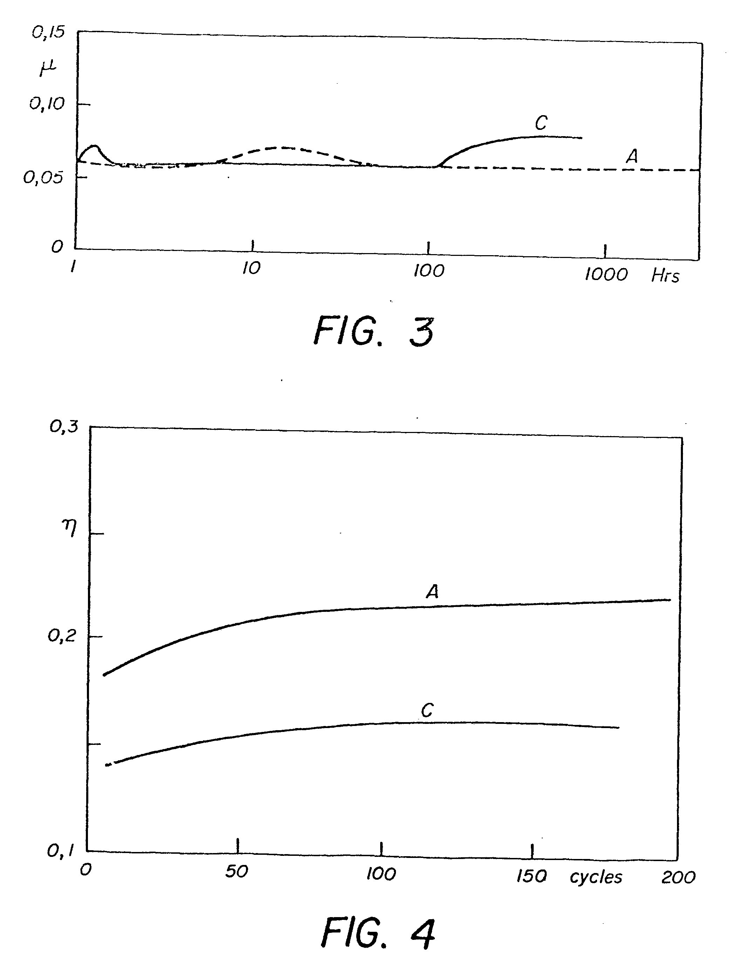

Ainsi à la figure 3, on a porté la variation du coefficient de friction avec le temps suivant le test "disque et bille" d'un revêtement A de 1 $\mu$m (obtenu à partir de la composition A ci-dessus) et d'un revêtement C de 1,1 $\mu$m (obtenu à partir de la composition C) sur un substrat d'acier finement poli (méthode P-3). On constate que, dans ce test, le revêtement A pauvre en soufre garde ses propriétés auto-lubrifiantes (>6000 h) plus longtemps que le revêtement C riche en soufre (~100 h). On a, par ailleurs, fait subir un traitement comparable à des revêtements d'épaisseur comparable obtenu par les moyens classiques (voir, par exemple les méthodes de dépôt par pulvérisation décrites dans les deux premières références citées dans l'introduction et, également la référence suivante: G. ROCHAT et al., Lubrification solide de mobiles micromécaniques, L.S.R.H. Conférence No F 2.6, CIC Genéve, 1979) et on a constaté que la résistance de tels dépôts à l'usure était considérablement inférieure à celle des dépôts turobstratiques de l'invention. En effet, les revêtements auo-lubrifiants classiques perdaient leurs propriétés après une période de l'ordre de 120 à 150 h seulement.

Cependant, pour deux revêtements identiques déposés sur laiton (polissage P-3), on a constaté que la composition C donnait un revêtement plus glissant que la composition A. Cet état de chose est illustré par la figure 4 où on a porté la variation de $\eta$ en fonction du nombre de cycles dans le test du pendule de Barker (courbe pointillée=résultats obtenus sur le revêtement A; courbe pleine=résultats obtenus sur le revêtement C).

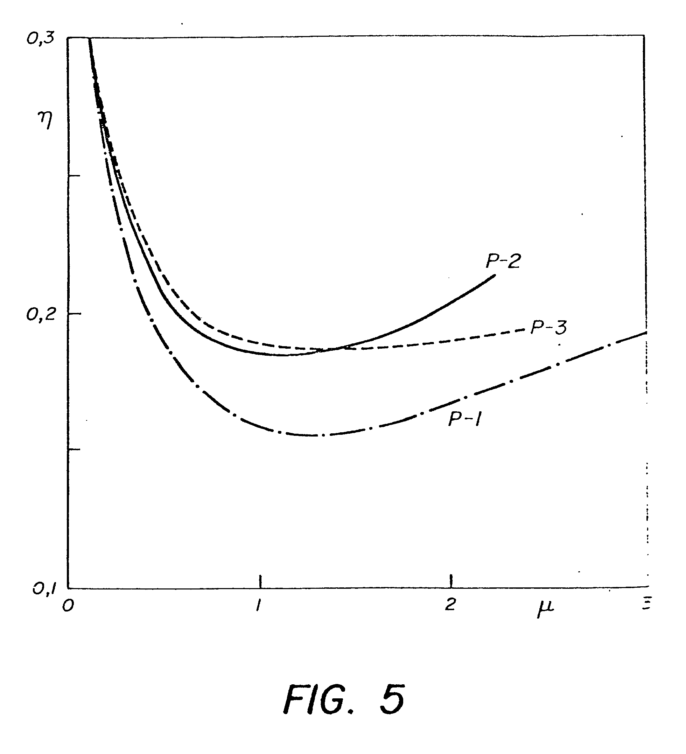

Par ailleurs, sur le graphique représenté à la figure 5, on a porté les variations du coefficient de friction (obtenu par les test du pendule de Barker) en fonction de l'épaisseur en $\mu$m du dépôt (composition C) sur acier Sandvik 17 AP et ceci pour des substrats polis suivant les méthodes décrites plus haut (P-1=courbe mixte; P-2=courbe pleine et P-3=courbe pointillée). On constate avec surprise que les revêtements les plus glissants sont obtenus sur les substrats les plus rugueux. Par ailleurs, l'epaisseur des dépôts conduisant au $\eta$ minimum est de l'ordre de 1 à 1,5 $\mu$m.

Exemple 2

On a sélectionné un lot de roues d'échappement de mouvements d'horlogerie qu'on a empilées les unes sur les autres en faisant coïncider leur trou central de manière obtenir un bloc cylindrique percé axialement. Par l'entremise de ce trou central, on a monté ce bloc sur l'axe d'un dispositif de mise en rotation, les faces planes du cylindre étant masquée, de part et d'autre, par des bagues de serrage en matière plastique. Le dispositif rotatif, mis en mouvement de l'extérieur par l'entremise d'une transmission à joints étanches a été placé en guise de porte-substrat dans un appareil de pulvérisation cathodique similaire à celui décrit à l'Exemple 1, Le dépôt de matière autolubrifiante étant destiné à recouvrir la partie externe des dents des roues d'échappement (la zone frappée par l'ancre du mouvement) celles-ci ont subi, auparavant, un traitement de polissage fin tel que décrit à l'exemple précedent. Dans certains cas, le polissage mécanique a été remplacé par un polissage électrolytique. Après polissage, les pièces ont été dégraissées et nettoycées comme décrit à l'Exemple 1.

Pour les dépôts on a utilisé des cibles de composition semblable à la composition C de l'Exemple 1 donnant des dépôts relativement riches en soufre et à des épaisseurs de 1 à 1,5 $\mu$m.

Les roues une fois revêtues ont été utilisées pour le montage de mouvements d'horlogerie et ces mouvements ont été testés sur un ampliscope GREINER permettent de déterminer l'amplitude des mouvements de l'axe du balancier. La grandeur de cette amplitude est en effet une mesure de la qualité lubrifiante des dents de l'échappement. On a constaté que, dans tous les cas, les propriétés auto-lubrifiantes des revêtements obtenus suivant l'invention étaient supérieures à celles des dépôts similaires obtenus par les moyens habituels, notamment par aspersion des surfaces frottantes par une dispersion de $MoS_2$ dans un solvant volatil ou dépôt par pulvérisation suivant la technique de Spalvins (voir référence citée dans l'introduction).

On notera que les revêtements auto-lubrifiants suivant l'invention sont également utiles sur d'autres pièces de mécanique et notámment les pièces horlogères en rotation, animées de mouvements d'oscillation ou subissant des efforts de frottement et/ou de percussion, telles que, par exemple, des éléments d'échappement, engrenages, roues, pivots, axes, paliers, cliquets, etc.

Exemple 3

On a déposé, sous $2 \cdot 10^{-3}$ Torr ($266 \times 10^{-3}$ Pascal) d'argon et une densité de courant 7 $mA/cm^2$ une série de chalcogénures métalliques dont la liste figure au Tableau ci-dessous. Les produits utilisés étaient des chalcogénures commerciaux qu'on a simplement séchés à l'air sans autre purification. Les tensions cathodiques et les rendements de placage sont également donnés au Tableau. Les propriétés de lubrification des dépôts obtenus (env. 1 $\mu m$) sur acier ont été testés au Pendule de Baxter, les coefficients de friction moyens figurent également au Tableau ci-dessous.

TABLEAU

| Dépôt | Tension cathodique V | Rendement $g/cm^2.min(\times 10^{-5})$ | Coefficient de friction |
|---|---|---|---|
| $WS_2$ | 820 | 7,12 | 0,2—0,4 |
| $MoSe_2$ | 620 | 9,6 | 0,08—0,15 |
| $MoTe_2$ | 620 | 12,9 | 0,3 inutilisable |
| $NbSe_2$ | 670 | 6,3 | 0,1 |
| $TaSe_2$ | 720 | 7,6 | non measurable, non lubrifiant |
| $MoS_2$ | 720 | 5,19 | 0,1 |

**Revendications**

1. Procédé pour déposer, par pulvérisation cathodique, un revétement auto-lubrifiant de chalcogénures métallique suivant lequel on projette sur une cible de matière à pulvériser, comprenant un ou plusieurs chalcogénures en mélange Choisis parmi le biséléniure de niobium le disulfure de molybdène et Te disulfure de tungstène, des ions fournis par une décharge cathodique développée au voisinage immédiat de ladite cible et en atmosphère de gaz raréfié, les matières ainsi arrachées à la cible se déposant sur un substrat placé en regard de ladite cible, l'espace cathodique de ladite cible étant soumis à un champ magnétique, caractérisé en ce qu'on règle la distance entre la cible et ledit substrat de manière qu'elle corresponde approximativement au libre parcours moyen des molécules arrachées à la cible et que la densité de courant de pulvérisation est telle que la vitesse de dépôt, sur la surface du substrat en regard de la cible soit d'au moins 0,1 $\mu m$/min. pour l'obtention d'un revêtement de structure turbostratique.

2. Procédé suivant la revendication 1, caractérisé par le fait que le champ magnétique est le 45 à 100 $10^3$ A/m, que ladite distance entre la cible et le substrat est de 1,5 à 7 cm et que la tension cathodique nécessaire à produire ledit courant est de 400 à 800 V sous une densité de courant cathodique de 5 à 20 $mA/cm^2$.

3. Procédé suivant la revendication 1, caractérisé par le fait que préalablement au dépôt, on soumet les substrats devant être revêtus à un traitement de décapage mécanique.

4. Procédé suivant la revendication 1, caractérisé par le fait que préalablement à la mise en action de la pulvérisation proprement dite, on soumet le substrat à un traitement de décapage ionique d'une durée de 1—4 minutes.

5. Procéde suivant la revendication 1, caractérisé par le fait que le revêtement de bichalcogénure turbostratique obtenu a une épaisseur de 0,5 à 3 $\mu m$.

6. Procédé selon l'une des revendications 1 à 5, caracterisé par le fait que la cible est constituée d'un mélange de chalcogenure métallique avec un excés de l'un ou qu'elle comprend en mélange avec le l'autre de ses composants à l'état élémentaire, le tout sous forme d'une poudre à l'état compacté permettant le dépôt d'une couche de composition en relation linéaire avec celle du mélange.

7. Procédé suivant la revendication 6, caractérisé parte fait que la cible est constitueé de bisulfure de molybdéne dont le contenu en soufre est compris entre 28 et 50%, le reste étant le molybdène, et permettant d'obtenir des dépôts contenant de 25 à 48% de soufre.

8. Procedé suivant la revendication 7, caractérisé par le fait que la cible contient 42,8% de soufre et que le dépôt qu'on en obtient contient 40,06% de soufre ce qui correspond à la stoechiométrie de la formule $MoS_2$.

**Patentansprüche**

1. Verfahren zur Ablagerung eines selbstschmierenden Ueberzugs metallischer Chalkogenide durch Kathodenzerstäubung, wobei man ein Target welches aus dem zu serstäubenden Werkstoff, der eines oder eine Mischung mehrerer der unter dem Niobdiselenid, dem Molybdändisulfid und dem Wolframdisulfid gewählten Chalkogenide enthält, mit Ionen beschiesst, die von einer Kathodenentladung, welche in unmittelbarer Umgebung des Targets und zwar in verdünntem Edelgas gezündet wurde, geliefert werden, wobei sich die so dem Target entrissenen Werkstoffteilchen auf eine dem Target gegenüberliegenden Unterlage ablagern, wobei der Kathodenraum des Targets einem Magnetfeld unterworfen wird, dadurch gekennzeichnet, dass man den Abstand zwischen dem Target und der Unterlage so regelt, dass er der freien Weglänge der dem Target entrissenene Moleküle entspricht, und dass die Zerstäubungsstromdichte so hoch ist, dass die Beschichtungsgeschwindigkeit auf der Oberfläche der Unterlage wenigstens 0,1 $\mu$m pro Minute beträgt, dies um eine Schicht mit turbostratischer Struktur zu erhalten.

2. Verfahren nach Anspruch 1, dadurch gekennzeichnet, dass die Magnetfeldstärke 45 bis 100 kA/m, der Abstand zwischen Target und Unterlage 1,5 bis 7 cm und die zur Erzeugung des Stromes notwendige Kathodenspannung von 400 bis 800 V beträgt, dies bei einer kathodischen Stromdichte von 5 bis 20 mA/cm$^2$.

3. Verfahren nach Anspruch 1, dadurch gekennzeichnet, dass man die zu beschichtenden Unterlagen vor der Beschichtung mechanisch abreibt.

4. Verfahren nach Anspruch 1, dadurch gekennzeichnet, dass man die Unterlagen vor der Zündung der eigentlichen Kathodenzerstäubung einer Ionenätzung von einer Dauer von 1—4 Minuten unterzieht.

5. Verfahren nach Anspruch 1, dadurch gekennzeichnet, dass der erhaltene turbostratischen Dichalgenidüberzug eine Dicke von 0,5 bis 3 $\mu$m aufweist.

6. Verfahren nach einem der Ansprüche 1 bis 5, dadurch gekennzeichnet, dass das Target aus einer Mischung von metallischen Chalkogeniden mit einem Ueberschuss des einen oder des anderen seiner elementaren Konstituenten in Form eines Presslings besteht, was es erlaubt eine Schicht, deren Zusammensetzung in linearen Verhältnis mit derjenigen der Mischung steht, abzulagern.

7. Verfahren nach Anspruch 6, dadurch gekennzeichnet, dass das Target aus Molybdändisulfid besteht, und sein Schwefelgehalt zwischen 28 und 50% liegt, wobei der Rest Molydän ist, welches es somit erlaubt, Ablagerungen mit einem Schwefelgehalt, der zwischen 25 und 48% liegt, zu erzeugen.

8. Verfahren nach Anspruch 7, dadurch gekennzeichnet, dass das Target 42,8% Schwefel und die somit erzeugte Ablagerungsschicht 40,06% Schwefel enthält, was der Stoïchiometrie der Formel $MoS_2$ entspricht.

**Claims**

1. A process for depositing, by cathode sputtering, a self-lubricating coating of metal chalcogenides, according to which a target of the material to be sputtered, comprising a chalcogenide or a mixture of chalcogenides selected among niobium diselenide molybdenum disulphide and tungsten disulphide, is bombarded with ions formed by a cathode discharge produced in the immediate vicinity of the said target and a rare gas atmosphere, the materials thus expelled from the target being deposited on a substrate placed opposite the said target, the cathode space of the said target being subjected to a magnetic field, characterized in that the distance between the target and the said substrate is adjusted so that it corresponds approximately to the mean free path of the molecules expelled from the target, and the sputtering current density is such that the rate of deposition on the surface of the substrate opposite the said target is at least 0.1 $\mu$m/minute, for obtaining a coating having a turbostratic structure.

2. A process according to claim 1, characterized in that the magnetic field is from 45 to 100 kA/m, the said distance between the target and the substrate is 1.5 to 7 cm, and the cathode voltage necessary to produce the said current is 400 to 800 V under a sputtering current density of 5 to 20 m A/cm$^2$.

3. A process according to claim 1, characterized in that the substrates that are to be coated are subjected, prior to deposition, to a mechanical scouring treatment.

4. A process according to claim 1, characterized in that, prior to the commencement of the sputtering as such, the substrate is subjected to an ion scouring treatment lasting from 1 to 4 minutes.

5. A process according to claim 1, characterized in that the turbostratic chalcogenide coating has a thickness from 0.5 to 3 $\mu$m.

6. A process according to any one of claims 1 to 5, characterized in that the target is constituted by a mixture of chalcogenides exhibiting an excess of one of its components in the elementary state, the whole being in the form of a compacted powder allowing to deposit a coating the composition of which is in linear relationship with that of the mixture.

7. A process according to claim 6, characterized in that the target is constituted by molybdenum disulphide whose sulphur content is between 28 and 50%, the rest being molybdenum, and enabling deposits containing from 25 to 48% of sulphur to be obtained.

8. A process according to claim 7, characterized in that the target contains 42.8% of sulphur and that the deposit which is obtained therefrom contains 40.06% of sulphur, which corresponds to the stoichiometric formula $MoS_2$.

FIG. 1

HT 8
$H_2O$
HT 9
Ar
11
10
13
12
7
3
4
1
6
5
2
14

% S
50
45
40
35
30
B
C
A
30
35
40
45
50
% S


FIG. 2

0,15
μ
0,10
0,05
0
C
A
1
10
100
1000
Hrs

FIG. 3

0,3
η
0,2
0,1
A
C
0
50
100
150
cycles
200

FIG. 4

0,3
η
0,2
0,1
0
1
2
μ
P-2
P-3
P-1

FIG. 5